# EUROPEAN PATENT SPECIFICATION

(11) **EP 3 061 142 B1**
(45) Date of publication and mention of the grant of the patent: **26.02.2020**
(21) Application number: 14803184.2
(22) Date of filing: 14.10.2014
(51) Int. Cl.: H01L 51/42, H01G 9/20

(54) **METHOD OF MAKING A PHOTOVOLTAIC DEVICE**
VERFAHREN ZUR HERSTELLUNG EINER PHOTOVOLTAISCHEN VORRICHTUNG
PROCÉDÉ DE FABRICATION D'UN DISPOSITIF PHOTOVOLTAÏQUE

(30) Priority: 23.10.2013 GB 201318737
(43) Date of publication of application: 31.08.2016
(73) Proprietor: Swansea University, Swansea SA2 8PP (GB)
(72) Inventor: WATSON, Trystan, Swansea SA2 8PP (GB); WORSLEY, David, Swansea SA2 8PP (GB); TROUGHTON, Jeol, Swansea SA2 8PP (GB); CARNIE, Matthew, Swansea SA2 8PP (GB)
(74) Representative: Symbiosis IP Limited
(86) International application number: PCT/GB2014/000412
(87) International publication number: WO 2015/059436

(56) References cited:
- EP-A1- 2 747 101
- LIOZ ETGAR ET AL: "Mesoscopic CH 3 NH 3 PbI 3 /TiO 2 Heterojunction Solar Cells", JOURNAL OF THE AMERICAN CHEMICAL SOCIETY, vol. 134, no. 42, 8 October 2012 (2012-10-08), pages 17396-17399, XP055083693, ISSN: 0002-7863, DOI: 10.1021/ja307789s
- TRYSTAN WATSON ET AL: "Ultrafast near infrared sintering of TiO2 layers on metal substrates for dye-sensitized solar cells", PROGRESS IN PHOTOVOLTAICS: RESEARCH AND APPLICATIONS, vol. 19, no. 4, 4 October 2010 (2010-10-04), pages 482-486, XP055170577, ISSN: 1062-7995, DOI: 10.1002/pip.1041
- MATTHEW J. CARNIE ET AL: "Ultra-fast sintered TiO2 films in dye-sensitized solar cells: phase variation, electron transport and recombination", JOURNAL OF MATERIALS CHEMISTRY A, vol. 1, no. 6, 17 December 2012 (2012-12-17), page 2225, XP055170579, ISSN: 2050-7488, DOI: 10.1039/c2ta01005d

## Description

### Field of the Invention

The invention relates to a method of making a photovoltaic device. In particular but not exclusively, this invention relates to the development of a rapid manufacturing process used to enhance the speed at which perovskite solar cells are fabricated.

### Background of the Invention

Dye sensitised solar cells (DSCs) typically consist of a working electrode and a counter electrode. The working electrode comprises a conductive substrate coated with a semiconductive nanoparticulate metal oxide such as Titanium dioxide (TiO₂) and a dye adsorbed onto the metal oxide to sensitize it to a larger portion of the solar spectrum. Dye-sensitized solar cells (DSSCs) have losses, both from electron transfer from the dye (or absorber) into the TiO₂, which requires a certain "driving force," and from dye regeneration from the electrolyte, which requires an over potential. Efforts have been made to reduce such losses in DSSCs.

An efficient solar cell must absorb over a broad spectral range, from visible to near-infrared (near-IR) wavelengths (350 to -950 nm), and convert the incident light effectively into charges. The charges must be collected at a high voltage with suitable current in order to do useful work. A simple measure of solar cell effectiveness at generating voltage is the difference in energy between the optical band gap of the absorber and the open-circuit voltage (V_{oc}) generated by the solar cell under simulated air mass (AM) 1.5 solar illumination of 100 mW cm⁻².

Inorganic semiconductor-sensitized solar cells have recently been used where a thin absorber layer of 2 to 10 nm in thickness, is coated upon the internal surface of a mesoporous TiO₂ electrode and then contacted with an electrolyte or solid-state hole conductor. These devices have achieved power conversion efficiencies of up to 6.3%. However, in such systems there are low open circuit voltages which may be a result of the electronically disordered, low-mobility n- type TiO₂.

Perovskites are relatively underexplored in the area of solar cells and they provide a framework for binding organic and inorganic components into a molecular composite. It has been shown that layered perovskites based on organometal halides demonstrate excellent performance as light-emitting diodes and transistors with mobilities comparable to amorphous silicon.

The manufacture of solar cells based upon perovskites has several procedural steps which increases manufacturing costs because the process takes more time and energy. Typically the process involves providing a glass substrate having a conductive coating; usually fluorine doped tin oxide (FTO,) on one surface of the substrate. The FTO layer is coated with TiO₂, a sintered layer of metal oxide nanoparticles is coated on the TiO₂ and then there is heat treatment to drive off binders etc. to form a nanoporous film. The nanoporous film is coated with a precursor including a perovskite that again is heat treated so that the solution crystallizes to form a solid perovskite light absorber and electron transporter. As a final stage a hole transport layer and metal contacts are added, see LIOZ ETGAR ET AL in JOURNAL OF THE AMERICAN CHEMICAL SOCIETY, vol. 134, no. 42, pages 17396-17399.

The use of sintering to drive off binders etc. means that considerable time is taken to process the structure and also there is the increased cost of heating.

TRYSTAN WATSON ET AL in PROGRESS IN PHOTOVOLTAICS: RESEARCH AND APPLICATIONS, vol. 19, no. 4, pages 482-486 teaches near infrared (NIR) sintering of TiO₂ layers in dye-sensitized solar cells. In particular, it makes a comparative study for identical dye-sensitized solar cells on Ti substrates using TiO₂ sintered using NIR and conventional oven. The results show that the time required for NIR sintering is only 12.5 s, while the time required for oven sintering at 500°C is 30 min for producing TiO₂ films with identical adhesion and mechanical properties.

MATTHEW J. CARNIE ET AL in JOURNAL OF MATERIALS CHEMISTRY A, vol. 1, no. 6, page 2225 also teaches ultrafast near infrared (NIR) sintering of TiO₂ films. The present invention seeks to overcome the problems of the prior art by providing a rapid and low temperature process in an extremely efficient photovoltaic device.

### Summary of the Invention

According to the present invention there is provided a method of making a photovoltaic device as defined in claim 1.

It is envisaged that the NIR radiation is applied having a wavelength in the range of 700 and 2500 nm to the precursor solution. The NIR treatment heats the precursor solution so the perovskite precursor solution crystallizes to form the scaffold.

More preferably the NIR radiation is applied at a wavelength in the range of 800 to 1200 nm and more preferably in the range of 900 to 1050 nm.

It is envisaged that the compact layer is formed from tin oxide.

It is preferred that there is a transparent conducting oxide forming a layer between the substrate and the compact layer.

It is envisaged that the transparent conducting oxide is fluorine doped tin oxide.

It is preferred that the compact layer and the transparent conducting oxide may be provided as a single integral layer.

It is preferred that the metal oxide nanoparticles are selected from one or more of titania, alumina or zirconia or a mixture thereof. In particular the nanoparticles are Al₂O₃.

It is preferred that the perovskite is an organometal halide. Typically the organometal halide is of the structure ABX₃ where A and B are cations and X represents anions.

Preferably the perovskite is CH₃NH₃PbX₃ where X is chlorine or bromine.

It is preferred that the percentage of metal oxide nanoparticles in the precursor solution containing the perovskite is 1 to 15% more preferable 1.5 to 12% and more particularly 2-7%.

Preferably the precursor solution is applied by spray pyrolysis in the presence of NIR or spin coating followed by NIR treatment.

It is preferred that the substrate is an electrochemically inert material selected from glass, a metal, plastic or carbon or a combination thereof.

It is envisaged that if metal is used the substrate is selected from one or more of gold, or platinum or a combination thereof.

The photovoltaic device formed by the claimed method includes a substrate and a compact layer which is coated with a precursor solution including metal oxide nanoparticles that form a scaffold for perovskites which can act as a perovskite light absorber and electron transporter through the compact layer when exposed to light.

Preferably the perovskite is an organometal halide. Typically the organometal halide is of the structure ABX₃ where A and B are cations and X represents anions.

It is envisaged that the perovskite is CH₃NH₃PbX₃ where X is chlorine or bromine.

It is preferred that the substrate is deformable so that the photovoltaic device can be shaped.

It is preferred that the exposure to NIR is performed in 5 to 50 seconds and more preferably in 5 to 25 seconds.

It is envisaged that the NIR is at a wavelength of 800 to 1200 nm.

According to yet a further aspect not forming part of the invention there is provided solar cell including a photovoltaic device having a substrate and a compact layer, said photovoltaic device further includes a scaffold containing metal oxide nanoparticles that support the perovskite formed from a perovskite precursor solution having been exposed to NIR radiation to form a porous scaffold having a perovskite light absorber and electron transporter therein.

As can be seen the invention allows for the production of a photovoltaic device which is resistant to damage, which can be rapidly produced and which has improved efficiency than known devices.

### Brief Description of the Drawings

An embodiment of the present invention will now be described by way of example only, with references to and as illustrated in the accompanying figures in which:

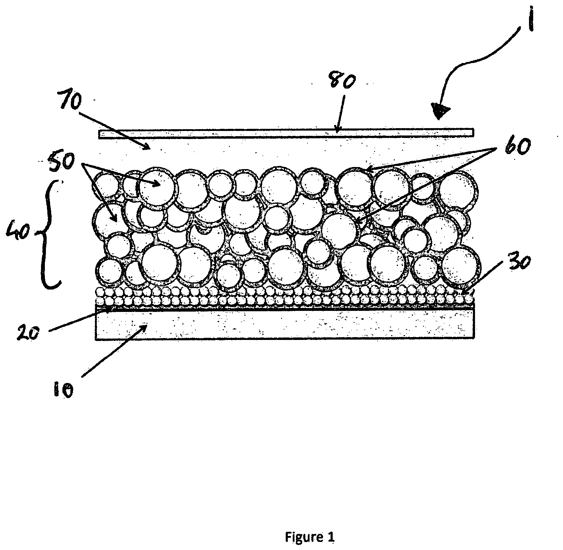

Figure 1 shows: a schematic diagram of a perovskite device according to an embodiment of the invention;

### Detailed Description of the Invention

As can be seen in Figure 1, a photovoltaic device to be used in a solar cell is generally shown as 1 and is formed of a glass substrate 10 which is coated with layer 20 provided as a semitransparent fluorine-doped tin oxide (FTO). A ZnO/HCl mix is used to remove any unwanted FTO. The glass is cleaned using water, surfactants, acetone, ethanol and dry N₂. A compact layer 30, typically of TiO₂ is then added and this acts as an anode. If glass is used the doped layer may be fluorine doped tin oxide on glass or indium tin oxide, which also may be provided on a plastic (e.g. PET or PEN) rather than glass. Having a plastic substrate means that the solar cells can be made flexible so they can be attached to a contoured surface.

The compact layer 30 may be applied to the glass in the form of a paste comprising a metal oxide in a binder and a solvent so that the oxide can be printed on a surface. The metal may also be a wide band gap metal oxide such as SnO₂ or ZnO or TiO₂. An advantage of SnO₂ is that it is easier to obtain good particle interconnectivity which will minimise resistive losses and increase the efficiency of the sensitized solar cell. An advantage of using ZnO is that ZnO nanoparticles are readily available at low material cost. There are however, several advantages are associated with using TiO₂, namely, TiO₂ is readily available, cheap, none-toxic and possesses good stability under visible radiation in solution, and an extremely high surface area suitable for dye adsorption. TiO₂ is also porous enough to allow good penetration by the electrolyte ions, and finally, TiO₂ scatters incident photons effectively to increase light harvesting efficiency. The compact TiO₂ blocking layer is 50nm in thickness for TiO₂ cells and 100 nm for Al₂O₃ cells and this may be applied by either via spraying pyrolysis or spin coating using 127µl Ti isopropoxide (99.99%) which is added to 845µl ethanol. 7µl HCI (2M) is added to the 845µl ethanol whilst stirring.

The next layer that is added is the photoactive layer 40 which included nanoparticles 50 and a perovskite precursor 60. The nanoparticles form a scaffold for the perovskite. The nanoparticles can be applied to the compact layer simultaneously with the perovskites or the nanoparticles and perovskite can be applied sequentially with the nanoparticles providing a preformed scaffold for the perovskites. The level of loading of the precursor with the nanoparticles has an impact on the efficiency of the device. A good performance is achieved when the precursor has a nanoparticle loading of 5% by weight and performance rises up to this level and declines afterwards and the efficiency of the devices formed is more consistent.

If the nanoparticles are applied simultaneously with the perovskites then ideally the two solutions should be compatible. The nano-particles are sold as a suspension either in water or IPA (isopropyl alcohol). If the solvents are often incompatible with the perovskite precursor solution and so the nanoparticles should be suspended in the same solvent as the perovskite precursor solution. This is achieved via solvent exchange in a rotary evaporator. The preferred solvents for the organometal halide perovskite precursor solution are either DMF (N,N-Dimethylformamide) or γ-butyrolactone. The precursor then consists of primary amine halide salt e.g. CH₃NH₃I (methyl ammonium lead iodide) and a lead halide salt e.g. PbCl₂ (lead chloride) dissolved in the solvent in the correct stoichiometry.

If the scaffold is laid down first, a paste of alumina or titania containing nanoparticles is prepared by dilution of Dyesol AO (a commercially available titania paste that contains ethyl cellulose as binder and ethanol and terpineol as solvents) with ethanol. This is then deposited onto the blocking layer glass and spin coated to produce a thin ∼0.5-lum layer of TiO₂ / Al₂O₃. This material is then sintered at approximately by heating, typically at 100-120°C for 40-60 minutes or 450°C for 30 minutes or by using NIR to produce a film containing the titania and/or alumina.

The perovskite is treated using NIR to rapidly crystallise the perovskites. The near- infrared region (NIR) of the electromagnetic spectrum is situated between the visible and the infrared at a wavelength of 700 nm to 2500 nm with a peak at around 1000 nm where typically polymer compounds do not have a strong absorbance. Where the nanoparticles and perovskite are applied simultaneously, the use of NIR radiation to rapidly cure, sinter and melt materials replace the need for a separate scaffold, effectively removing a processing step from the manufacturing process as outlined previously. NIR heating was achieved by moving the sample to be heated at a set speed, determined by the operator, under the emitters at a pre-set but variable power level. Altering the speed of the sample holder allowed the time of NIR exposure to the sample to be varied between 1.4 and 2.4 seconds. The NIR is provided by an NIR source 8 such as Adphos lamps.

To complete the photoactive layer, the perovskite-coated porous electrode was further filled with the hole transporter 70. Hole transport mediums (HTMs) have been developed as a solid alternative to liquid electrolytes. They function as an electron conduction path from a counter electrode to dyes desorbed onto the TiO₂ surface. To perform this function spiro-(OMeTAD) (2,2'7,7'-tetrakis (N,N-di-p-methoxyphenylamine)-9,9'-spirobifluorene) is the most popular hole transporter used showing decent charge carrier mobility. Here the electron transfer process occurs by a hole injection from the oxidised dye into the HTM. Electron conduction then transports the electron through the TiO₂ and hole through the HTM to an electrode 80. The electrode 80 forms a final layer and is typically a highly conductive metal provided typically as a silver or gold electrode or alternatively a grid can be printed on the photoactive layer to provide an electrode.

Typically charge collection in Al₂O₃ -based devices was faster than in the TiO₂-based sensitized devices by a factor of >10, indicating faster electron diffusion through the perovskite phase than through the n-type TiO₂. Perovskites tend to form layered structures, with continuous two-dimensional metal halide planes perpendicular to the z axis and the lower dielectric organic components (methyl amine) between these planes. This quasi-two-dimensional confinement of the excitons can result in an increased exciton binding energy, which can be up to a few hundred millielectron volts.

The application of a mesostructured insulating scaffold upon which extremely thin films of n-type and p-type semiconductors are assembled, termed the meso-superstructured solar cell (MSSC), has proven to be extraordinarily effective with an n-type perovskite. The light absorption near the band edge can be enhanced through carefully engineered mesostructures and by optimising the nanoparticle to perovskite ratio. The loading of the perovskite precursor with a certain level of nanoparticles provides and optimised scaffold having a maximized surface area so that photovoltaic properties can be exploited as planar junction devices having efficiencies of around 1.8% to also because a low temperature process can be used, it is envisaged that the precursor can be simply painted onto a substrate and heat treated in situ to provide the solid perovskite light absorber and transporter. Efficiency data for MSSC's cured using NIR at a) 40% power and b) 50% power show that using NIR reaches close to the efficiency of oven cured standards, whilst enabling a rapid processing. The best average performing NIR settings cure the perovskite in under 8.5 seconds compared with 1 hour in an oven. Further optimising NIR lamp power and speed settings may bring the fast-cured device performance up to the same level as the oven-cured standard.

As can be seen, the invention has particular benefits in that it avoids having to use an expensive and time consuming processing step of sintering. Further, the perovskite grows into a continuous network so forming a scaffold for the solar cell and so provides a rapid and cost effective way of manufacturing solar cells.

## Claims

1. A method of making a photovoltaic device (1) including:
providing a substrate (10);
forming a compact layer (30) on the substrate (10);
**characterised in that**:
a) the compact layer is coated with a perovskite precursor solution including metal oxide nanoparticles and a perovskite precursor and said perovskite precursor solution is exposed to NIR radiation so the metal oxide nanoparticles form a scaffold (50) for the perovskites (60) formed from the perovskite precursor solution which can allow for light absorption and electron transportation in the compact layer (30) when exposed to light, following which a conductor layer is attached to the scaffold, or
b) a precursor solution including metal oxide is formed on the compact layer (30) and treated with NIR radiation to form a scaffold (50) and then a perovskite precursor solution is applied to the scaffold and exposed to NIR radiation so the perovskites formed from the perovskite precursor solution can allow for light absorption and electron transportation in the compact layer (30) when exposed to light, following which a conductor layer is attached to the scaffold (50).

2. A method according to claim 1, wherein the NIR radiation has a wavelength in the range of 700 and 2500 nm and more preferably in the range of 800 to 1200 nm and even more preferably in the range of 900 to 1050 nm.

3. A method according to claim 1 or claim 2, wherein the exposure to NIR is for 5 to 50 seconds and more preferably for 5 to 25 seconds.

4. A method according to any preceding claim wherein the compact layer is formed from tin oxide.

5. A method according to claim 4, wherein there is a transparent conducting oxide forming a layer between the substrate and the compact layer.

6. A method according to claim 5, wherein the transparent conducting oxide is fluorine doped tin oxide.

7. A method according to claim 6, wherein the compact layer and the transparent conductive oxide is provided as a single integral layer.

8. A method according to any preceding claim wherein the metal oxide nanoparticles are selected from one or more of titania, alumina or zirconia or a mixture thereof, in particular the nanoparticles are Al₂O₃.

9. A method according to any preceding claim wherein the perovskite is an organometal halide.

10. A method according to claim 9, wherein the organometal halide is of the structure ABX₃ where A and B are cations and X represents anions.

11. A method according to claim 9 or claim 10, wherein the perovskite is CH₃NH₃PbX₃ where X is chlorine or bromine.

12. A method according to any preceding claim wherein the percentage of metal oxide nanoparticles in the perovskite precursor solution is 1 to 15% more preferable 1.5 to 12% and more particularly 2-7%.

13. A method according to any preceding claim wherein the precursor solution is applied by spray pyrolysis in the presence of NIR or spin coating followed by NIR treatment.

14. A method according to any preceding claim wherein the substrate (10) is selected from glass, a metal, plastic or carbon or a combination thereof.

## Patentansprüche

1. Verfahren zur Herstellung einer photovoltaischen Vorrichtung (1), Folgendes beinhaltend:
Bereitstellen eines Substrats (10);
Bilden einer kompakten Schicht (30) auf dem Substrat (10);
**dadurch gekennzeichnet, dass**:
a) die kompakte Schicht mit einer Perovskitvorläuferlösung beschichtet ist, die Metalloxidnanopartikel und einen Perovskitvorläufer beinhaltet, und die Perovskitvorläuferlösung NIR-Strahlung ausgesetzt wird, sodass die Metalloxidnanopartikel ein Gerüst (50) für die Perovskite (60) bilden, die aus der Perovskitvorläuferlösung gebildet werden, die Lichtabsorption und Elektronentransport in der kompakten Schicht (30) ermöglichen, wenn sie Licht ausgesetzt ist, und auf die folgend eine Leiterschicht an dem Gerüst angebracht ist, oder
b) eine Vorläuferlösung, die Metalloxid beinhaltet, auf der kompakten Schicht (30) gebildet und mit NIR-Strahlung behandelt wird, um ein Gerüst (50) zu bilden, und dann eine Perovskitvorläuferlösung auf das Gerüst aufgetragen und NIR-Strahlung ausgesetzt wird, damit die Perovskite, die sich aus der Perovskitvorläuferlösung bilden, Lichtabsorption und Elektronentransport in der kompakten Schicht (30) ermöglichen, wenn sie Licht ausgesetzt ist, auf die folgend eine Leiterschicht an dem Gerüst (50) angebracht ist.

2. Verfahren nach Anspruch 1, wobei die NIR-Strahlung eine Wellenlänge im Bereich von 700 bis 2500 nm, und vorzugsweise im Bereich von 800 bis 1200 nm, und noch bevorzugter im Bereich von 900 bis 1050 nm aufweist.

3. Verfahren nach Anspruch 1 oder Anspruch 2, wobei das Aussetzen gegenüber NIR 5 bis 50 Sekunden, und vorzugsweise 5 bis 25 Sekunden andauert.

4. Verfahren nach einem der vorhergehenden Ansprüche, wobei die kompakte Schicht aus Zinnoxid gebildet ist.

5. Verfahren nach Anspruch 4, wobei ein transparentes leitendes Oxid eine Schicht zwischen dem Substrat und der kompakten Schicht bildet.

6. Verfahren nach Anspruch 5, wobei das transparente leitende Oxid fluordotiertes Zinnoxid ist.

7. Verfahren nach Anspruch 6, wobei die kompakte Schicht und das transparente leitende Oxid von einer einzigen integralen Schicht gebildet werden.

8. Verfahren nach einem der vorhergehenden Ansprüche, wobei die Metalloxidnanopartikel ausgewählt sind aus einem oder mehreren von Titanoxid, Aluminiumoxid oder Zirkonoxid oder einer Mischung daraus, und genauer wobei die Nanopartikel aus Al₂O₃ bestehen.

9. Verfahren nach einem der vorhergehenden Ansprüche, wobei das Perovskit ein metallorganisches Halogenid ist.

10. Verfahren nach Anspruch 9, wobei das metallorganische Halogenid die Struktur ABX₃ aufweist, wobei A und B Kationen sind, und X Anionen darstellt.

11. Verfahren nach Anspruch 9 oder Anspruch 10, wobei das Perovskit CH₃NH₃PbX₃ ist, wobei X Chlor oder Brom ist.

12. Verfahren nach einem der vorhergehenden Ansprüche, wobei der Prozentsatz von Metalloxidnanopartikeln in der Perovskitvorläuferlösung 1 bis 15%, oder vorzugsweise 1,5 bis 12%, und genauer 2-7% beträgt.

13. Verfahren nach einem der vorhergehenden Ansprüche, wobei die Vorläuferlösung durch Sprühpyrolyse in Gegenwart von NIR, oder durch Schleuderbeschichten gefolgt von NIR-Behandlung, aufgetragen wird.

14. Verfahren nach einem der vorhergehenden Ansprüche, wobei das Substrat (10) aus einem von Glas, einem Metall, Kunststoff oder Kohlenstoff oder einer Kombination davon, ausgewählt wird.

## Revendications

1. Procédé de fabrication d'un dispositif photovoltaïque (1) comprenant :
la fourniture d'un substrat (10) ;
la formation d'une couche compacte (30) sur le substrat (10) ;
**caractérisé en ce que** :
a) la couche compacte est revêtue d'une solution de précurseur de pérovskite comprenant des nanoparticules d'oxyde métallique et un précurseur de pérovskite et ladite solution de précurseur de pérovskite est exposée à un rayonnement NIR de sorte que les nanoparticules d'oxyde métallique forment un échafaudage (50) pour les pérovskites (60) formées à partir de la solution de précurseur de pérovskite qui peuvent permettre une absorption de lumière et un transport d'électrons dans la couche compacte (30) lorsqu'elles sont exposées à de la lumière, après quoi une couche conductrice est attachée à l'échafaudage, ou
b) une solution de précurseur comprenant un oxyde métallique est formée sur la couche compacte (30) et traitée avec un rayonnement NIR pour former un échafaudage (50), puis une solution de précurseur de pérovskite est appliquée sur l'échafaudage et exposée à un rayonnement NIR de sorte que les pérovskites formées à partir de la solution de précurseur de pérovskite peuvent permettre une absorption de lumière et un transport d'électrons dans la couche compacte (30) lorsqu'elles sont exposées à de la lumière, après quoi une couche conductrice est attachée à l'échafaudage (50).

2. Procédé selon la revendication 1, dans lequel le rayonnement NIR a une longueur d'onde dans la plage de 700 à 2 500 nm et de manière davantage préférée dans la plage de 800 à 1 200 nm et de manière encore plus préférée dans la plage de 900 à 1 050 nm.

3. Procédé selon la revendication 1 ou la revendication 2, dans lequel l'exposition au NIR s'effectue pendant 5 à 50 secondes et de manière davantage préférée pendant 5 à 25 secondes.

4. Procédé selon une quelconque revendication précédente, dans lequel la couche compacte est formée à partir d'oxyde d'étain.

5. Procédé selon la revendication 4, dans lequel un oxyde conducteur transparent forme une couche entre le substrat et la couche compacte.

6. Procédé selon la revendication 5, dans lequel l'oxyde conducteur transparent est de l'oxyde d'étain dopé au fluor.

7. Procédé selon la revendication 6, dans lequel la couche compacte et l'oxyde conducteur transparent sont fournis sous la forme d'une couche solidaire unique.

8. Procédé selon une quelconque revendication précédente, dans lequel les nanoparticules d'oxyde métallique sont sélectionnées parmi un ou plusieurs du titane, de l'alumine ou de la zircone ou un mélange de ceux-ci, en particulier les nanoparticules sont en Al₂O₃.

9. Procédé selon une quelconque revendication précédente, dans lequel la pérovskite est un halogénure organométallique.

10. Procédé selon la revendication 9, dans lequel l'halogénure organométallique est de structure ABX₃ où A et B sont des cations et X représente des anions.

11. Procédé selon la revendication 9 ou la revendication 10, dans lequel la pérovskite est CH₃NH₃PbX₃ où X est le chlore ou le brome.

12. Procédé selon une quelconque revendication précédente, dans lequel le pourcentage de nanoparticules d'oxyde métallique dans la solution de précurseur de pérovskite est de 1 à 15 %, de manière davantage préférée de 1,5 à 12 % et plus particulièrement de 2 à 7 %.

13. Procédé selon une quelconque revendication précédente, dans lequel la solution de précurseur est appliquée par pulvérisation pyrolytique en présence de NIR ou dépôt à la tournette suivi par un traitement au NIR.

14. Procédé selon une quelconque revendication précédente, dans lequel le substrat (10) est sélectionné parmi le verre, un métal, le plastique ou le carbone ou une combinaison de ceux-ci.
